# EUROPÄISCHE PATENTSCHRIFT

(11) **EP 3 033 616 B1**
(45) Veröffentlichungstag und Bekanntmachung des Hinweises auf die Patenterteilung: **08.07.2020**
(21) Anmeldenummer: 14748189.9
(22) Anmeldetag: 01.08.2014
(51) Int. Cl.: G01N 27/90, H05K 1/16

(54) **MEHRSCHICHT-WIRBELSTROMSONDE, VERFAHREN ZUR HERSTELLUNG EINER MEHRSCHICHT-WIRBELSTROMSONDE UND PRÜFGERÄT MIT MEHRSCHICHT-WIRBELSTROMSONDE**
MULTI-LAYERED EDDY CURRENT PROBE, METHOD OF MANUFACTURING AND TEST INSTRUMENT WITH SAID PROBE
SONDE MULTICOUCHE A COURANTS DE FOUCAULT, METHODE DE FABRICATION ET APPAREIL DE CONTRÔLE AVEC LADITE SONDE

(30) Priorität: 13.08.2013 DE 102013216019
(43) Veröffentlichungstag der Anmeldung: 22.06.2016
(73) Patentinhaber: Magnetische Prüfanlagen GmbH, 72766 Reutlingen (DE)
(72) Erfinder: KUDYAKOV, Timur, 72072 Tübingen (DE)
(74) Vertreter: Patentanwälte Ruff, Wilhelm, Beier, Dauster & Partner mbB
(86) Internationale Anmeldenummer: PCT/EP2014/066660
(87) Internationale Veröffentlichungsnummer: WO 2015/022210

(56) Entgegenhaltungen:
- EP-A1- 1 885 019
- DE-U1- 29 803 750
- DE-U1-202004 002 448
- US-A- 5 111 412
- US-A- 5 389 876

## Beschreibung

Die Erfindung betrifft eine Mehrschicht-Wirbelstromsonde gemäß dem Oberbegriff von Anspruch 1, ein Verfahren zur Herstellung einer solchen Mehrschicht-Wirbelstromsonde sowie ein Wirbelstrom-Prüfgerät mit mindestens einer solchen Mehrschicht-Wirbelstromsonde.

Bei der zerstörungsfreien Werkstoffprüfung (non-destructive testing, NDT) elektrisch leitender Materialien hat sich die Wirbelstromprüfung in vielen Anwendungsgebieten bewährt, beispielsweise bei der automatisierten zerstörungsfreien Prüfung an Halbzeugen für die metallerzeugende und metallverarbeitende Industrie, zur Durchführung von Prüfungen an sicherheitsrelevanten und funktionskritischen Bauteilen für Land- und Luftfahrzeuge oder im Anlagenbau. Die für die Wirbelstromprüfung eingesetzten bzw. verwendeten Sensorsysteme werden üblicherweise als "Wirbelstromsonden" bezeichnet.

Bei der Wirbelstromprüfung wird eine Wirbelstromsonde in einem geringen Prüfabstand zu einer zu prüfenden Oberfläche eines Prüflings angeordnet. Der Prüfling besteht zumindest im Bereich der Oberfläche aus einem elektrisch leitenden Material. Für die Prüfung wird in der Regel eine Relativbewegung zwischen Prüfling und Wirbelstromsonde erzeugt, beispielsweise indem die Wirbelstromsonde den zu prüfenden Bereich der Oberfläche überfährt.

Eine mit Spulen aufgebaute Wirbelstromsonde umfasst eine oder mehrere Feldspulen (bzw. Erregerspulen), die zur Durchführung der Prüfung an einer Wechselspannungsquelle angeschlossen werden und dann ein hochfrequentes elektromagnetisches Wechselfeld erzeugen können, welches bei der Prüfung in das Prüfmaterial eindringt und im Wesentlichen in einer oberflächennahen Schicht des Prüfmaterials Wirbelströme erzeugt, die durch Gegeninduktion auf ein oder mehrere Messspulen (bzw. Empfängerspulen) der Wirbelstromsonde zurückwirken. Ein Defekt im geprüften Bereich, beispielsweise ein Riss, eine Verunreinigung oder eine andere Materialinhomogenität, stört die Ausbreitung der Wirbelströme im Prüfmaterial und verändert somit die Wirbelstromintensität und dadurch auch die Intensität des auf die Messspule rückwirkenden magnetischen Sekundärfeldes. Die dadurch verursachten Impedanzänderungen in einer Messspule führen zu elektrischen Messsignalen, die mittels einer Auswerteeinrichtung ausgewertet werden können, um Defekte zu identifizieren und zu charakterisieren. Wirbelstromsonden, bei denen eine Kopplung zwischen den Feldspulen (Erregerspulen) und den davon gesonderten Messspulen vermittelt über das Prüflingsmaterial erfolgt, werden als transformatorische Wirbelstromsonden bezeichnet.

Während Wirbelstromsonden älterer Generationen typischerweise mit aus Draht gewickelten Spulen aufgebaut wurden, werden heutzutage zusätzlich auch Wirbelstromsonden verwendet, die mit Verfahren der Leiterplattentechnik nach Art von gedruckten Schaltungen hergestellt werden können. Hierzu gehören gattungsgemäße Mehrschicht-Wirbelstromsonden, die eine Mehrschichtanordnung mit einer Vielzahl von spiralförmigen Flachspulen aufweisen, welche in unterschiedlichen Spulenschichten der Mehrschichtanordnung angeordnet sind, wobei zwischen unmittelbar benachbarten Spulenschichten jeweils eine Isolierschicht aus einem elektrisch isolierenden Material angeordnet ist.

Jede der Flachspulen hat ein inneres Anschlussende an der inneren Windung und ein äußeres Anschlussende an der äußeren Windung der Flachspule. Die Anschlussenden ("terminals") dienen der elektrischen Verschaltung der Flachspulen mit anderen Flachspulen oder externen Komponenten. Um Flachspulen aus unterschiedlichen Schichten elektrisch miteinander zu verschalten, sind ausgewählte Anschlussenden von ausgewählten Flachspulen unterschiedlicher Spulenschichten mittels Durchkontaktierungen elektrisch miteinander verbunden. Eine Durchkontaktierung (im Englischen: "Vertical Interconnect Access, VIA) ist eine vertikale, d.h. im Wesentlichen senkrecht zu den Schichten verlaufende elektrische Verbindung zwischen Flachspulen in unterschiedlichen Spulenschichten. Die Verbindung kann beispielsweise durch eine innen metallisierte Bohrung im Material der Isolierschicht realisiert werden.

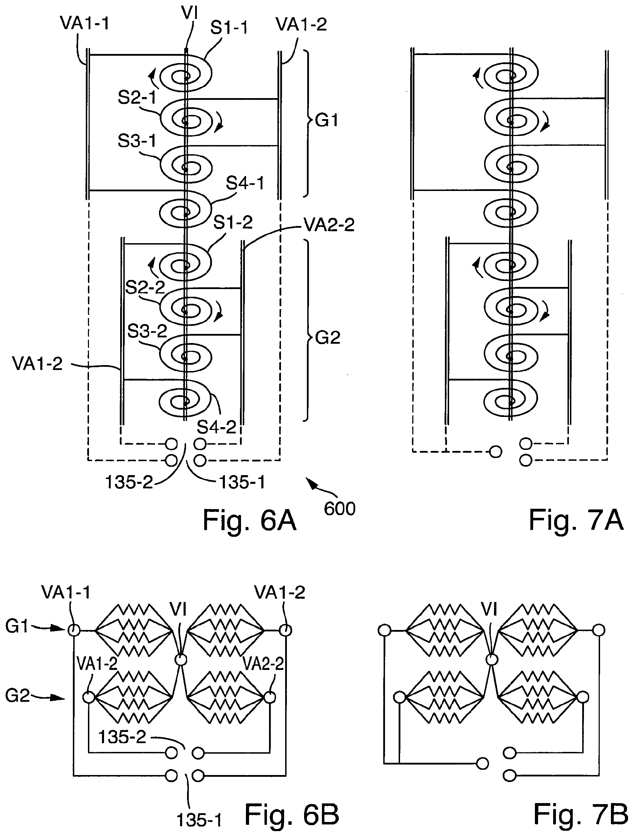

Das Patent US 5,389,876 (siehe auch EP 0 512 796 B1) beschreibt Mehrschicht-Wirbelstromsonden, die eine Vielzahl von gleichen Flachspulen aufweisen, die in einer flexiblen, vielschichtigen integrierten Wirbelstrom-Sondenanordnung gekapselt sind. Bei einer Ausführungsform (Fig. 6a, 6b) gibt es Spulenpaare mit jeweils zwei Flachspulen, die übereinander in unterschiedlichen Spulenschichten angeordnet sind. Die Windungen der beiden Flachspulen verlaufen gegensinnig zueinander. Die inneren Anschlussenden der Flachspulen sind über eine Durchkontaktierung miteinander verbunden. Dadurch sind die Flachspulen des Spulenpaares elektrisch in Reihe geschaltet, wodurch zu einem gegebenen Zeitpunkt ein Strom durch die Windungen beider Flachspulen in der gleichen Umlaufrichtung fließt, so dass sich bei Beaufschlagung mit einer Wechselspannung die Felder beider Flachspulen addieren. Bei einer anderen Ausführungsform (Fig. 8) sind zwei derartige Spulenpaare vertikal so ineinander geschachtelt, dass zwischen den Flachspulen eines ersten Spulenpaares in Vertikalrichtung eine Flachspule eines zweiten Spulenpaares angeordnet ist. Die zusammengehörenden Flachspulen eines Spulenpaares sind jeweils über eine innere Durchkontaktierung verbunden, die die inneren Anschlussenden der zusammengehörenden Flachspulen verbinden, so dass die windungsfreien Innenbereiche der beiden innen liegenden Flachspulen jeweils von zwei Durchkontaktierungen durchsetzt sind.

Die EP 2 056 103 B1 zeigt ebenfalls flexible Mehrschicht-Wirbelstromsonden mit Spulenpaaren, die aus jeweils zwei Flachspulen bestehen, die übereinander in unterschiedlichen Spulenschichten angeordnet sind, wobei die Windungen der beiden Flachspulen gegensinnig zueinander verlaufen und die inneren Anschlussenden der Flachspulen über eine Durchkontaktierung miteinander verbunden sind.

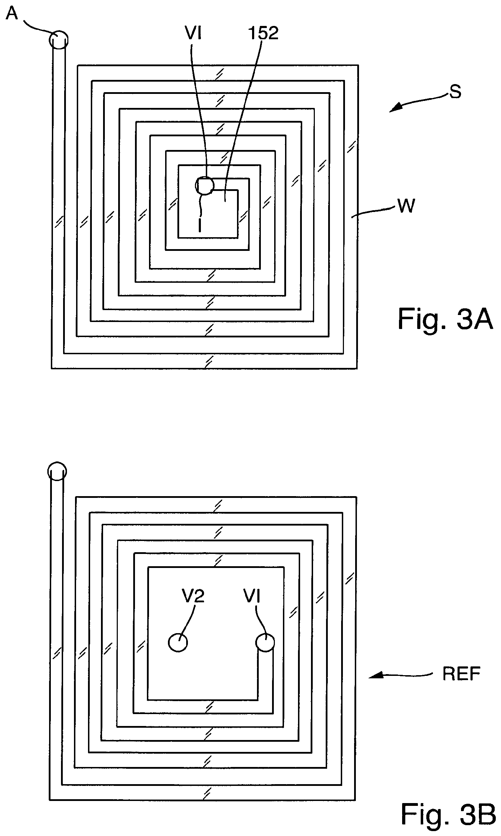

Die Patentschrift US 5,111,412 beschreibt zusammengesetzte Wandler (transducer), die mit spiralförmigen Flachspulen aufgebaut sind und die als Wirbelstromsonden zur Verwendung in einem Wirbelstrom-Prüfgerät zur zerstörungsfreien Werkstoffprüfung elektrisch leitender Materialien verwendet werden können. Zwar ist in Figur 3 nur eine einzige Lage gezeigt, es ist jedoch auch angegeben, dass bei Bedarf mehrere gedruckte Laminate übereinander gestapelt werden und mit Durchkontaktierungen verbunden werden können, um sie elektrisch in Serie oder elektrisch parallel zu verbinden.

### AUFGABE UND LÖSUNG

Der Erfindung liegt die Aufgabe zugrunde, eine Mehrschicht-Wirbelstromsonde der eingangs erwähnten Art bereitzustellen, die relativ kostengünstig herstellbar ist und eine Wirbelstromprüfung mit hoher Empfindlichkeit auch für kleine Defekte ermöglicht.

Zur Lösung dieser und anderer Aufgaben wird eine Mehrschicht-Wirbelstromsonde mit den Merkmalen von Anspruch 1, ein Wirbelstrom-Prüfgerät mit einer derartigen Mehrschicht-Wirbelstromsonde mit den Merkmalen von Anspruch 9 sowie ein Verfahren zur Herstellung einer solchen Mehrschicht-Wirbelstromsonde mit den Merkmalen von Anspruch 11 bereitgestellt.

Vorteilhafte Weiterbildungen sind in den abhängigen Ansprüchen angegeben. Der Wortlaut sämtlicher Ansprüche wird durch Bezugnahme zum Inhalt der Beschreibung gemacht.

Bei einer Mehrschicht-Wirbelstromsonde gemäß der beanspruchten Erfindung bilden die Flachspulen mindestens eine Spulengruppe, welche mindestens drei Flachspulen aufweist, die in unterschiedlichen Schichten übereinander angeordnet sind, wobei die inneren Anschlussenden der mindestens drei Flachspulen der Spulengruppe über eine gemeinsame innere Durchkontaktierung elektrisch leitend verbunden sind.

Eine "Flachspule" (auch als "pancake coil" bezeichnet) im Sinne dieser Anmeldung ist eine Spule mit Windungen, die in einer gemeinsamen, ebenen oder leicht gekrümmten Fläche spiralförmig ineinander liegend verlaufen, wobei typischer Weise alle Windungen der Flachspule in dieser Fläche liegen. Die Windungen umschließen einen Innenbereich, der frei von Windungen ist. Am Innenbereich liegt das innere Anschlussende. Der von den Windungen eine Flachspule bedeckte Bereich zuzüglich des Innenbereichs wird hier als "Spulenfläche" bezeichnet und kann durch einen (äußeren) Spulendurchmesser charakterisiert werden. Die Windungen können kontinuierlich gekrümmt verlaufen, um eine mehr oder weniger runde oder ovale Spulenform zu erhalten. Windungen können auch abschnittsweise geradlinig verlaufen und Ecken bilden, so dass eine polygonale Spulenform, z.B. eine quadratische Spulenform entsteht. Eine "Spulengruppe" hat drei oder mehr Flachspulen, die in einer senkrecht zur Schichtausdehnung liegenden Richtung ("Vertikalrichtung") übereinander in unterschiedlichen Spulenschichten angeordnet und durch zwischenliegende Isolierschichten elektrisch gegeneinander isoliert sind. Die inneren Anschlussenden aller zur Spulengruppe gehörenden Flachspulen liegen mehr oder weniger übereinander und sind elektrisch über eine einzige gemeinsame innere Durchkontaktierung verbunden.

Wenn drei oder mehr Flachspulen einer (vertikalen) Spulengruppe übereinander angeordnet sind, addiert sich deren Wirkung im oberflächennahen Bereich des Prüflings in einem relativ kleinen Wirkbereich, der unter anderem von der lateralen Ausdehnung der Flachspulen bzw. den Spulenflächen und der darin untergebrachten Anzahl der Windungen abhängt. Die Flachspulen der Spulengruppe können in direkt benachbarten Schichten angeordnet sein. Es ist jedoch auch möglich, dass zwischen benachbarten Flachspulen einer Spulengruppe eine oder mehrere Flachspulen angeordnet sind, die nicht zu der Spulengruppe gehören. In diesem Fall würde die innere Durchkontaktierung auch diese Flachspulen in deren Innenbereich durchdringen, ohne jedoch mit den zugehörigen Windungen elektrisch verbunden zu sein.

Die gemeinsame innere Durchkontaktierung erlaubt eine elektrische Parallelschaltung von zwei oder mehr gleichsinnig wirkenden Flachspulen der Spulengruppe mit nur einer oder zwei weiteren Durchkontaktierungen. Einer Spulengruppe können auch mehr als zwei äußere Durchkontaktierungen zugeordnet sein, z.B. vier oder mehr. Werden die Flachspulen der Spulengruppe gemeinsam an eine Wechselspannungsquelle einer Leistungsversorgung angeschlossen, so können sie als Feldspulen (Erregerspulen) genutzt werden. Die Felder der mindestens drei Flachspulen überlagern sich und wirken am gleichen Ort des Prüflings. Wenn bei der Verschaltung sichergestellt wird, dass die Flachspulen zu einem gegebenen Zeitpunkt jeweils von Strom mit der gleichen Umlaufrichtung durchflossen werden, so addieren sich die durch die jeweiligen Flachspulen erzeugten elektromagnetischen Felder am gleichen Ort im Prüfling, so dass eine starke lokale Konzentration der Erregungsfeldstärke im Prüfling am Ort der Spulengruppe erreicht werden kann.

Da drei oder mehr Flachspulen einer Spulengruppe über einzige eine gemeinsame innere Durchkontaktierung elektrisch verschaltet sind, kann die Anzahl von Durchkontaktierungen im Innenbereich einer Spulengruppe im Vergleich zum Stand der Technik reduziert werden. Dadurch ist es möglich, die Größe des windungsfreien Innenbereichs der Flachspulen zu reduzieren bzw. zum Aufbringen von Windungen zu nutzen, so dass in einer Flachspule bei gleichem Außendurchmesser bzw. gleicher Spulenfläche durch Nutzung von Teilen des Innenbereichs im Vergleich zum Stand der Technik mehr Windungen untergebracht werden können. Dadurch steigt die auf die Spulenfläche bezogene Windungszahl, wodurch beispielsweise bei Verwendung als Feldspule bei gleichem Erregerstrom stärkere elektromagnetische Felder erzeugt werden können. Alternativ oder zusätzlich ist auch möglich, Flachspulen bei gleicher Windungszahl mit kleinerer Spulenfläche zu erzeugen, wodurch die Ortsauflösung der Wirbelstromsonde erhöht werden kann.

Das Konzept erlaubt eine Reduzierung der Anzahl von Durchkontaktierungen im Vergleich zu herkömmlichen Mehrschichtanordnungen mit ähnlicher Anzahl von übereinander angeordneten Flachspulen. Dadurch wird die Herstellung einfacher und kostengünstiger. Vorzugsweise sind alle Flachspulen einer Spulengruppe nach der Herstellung an die gleiche innere Durchkontaktierung angeschlossen, so dass bei jeder der Flachspulen der Spulengruppe in einem von Windungen umgebenden Innenbereich nur eine einzige Durchkontaktierung der Spulengruppe angeordnet ist. Zusätzlich können noch eine oder mehrere Durchkontaktierungen von Messspulen durch den Innenbereich hindurchlaufen.

Bei vorteilhaften Weiterbildungen weist die Spulengruppe mindestens vier Flachspulen auf, die in unterschiedlichen Schichten übereinander angeordnet sind. Dadurch ist eine Verstärkung der gemeinsamen Wirkung der Spulen erzielbar. Außerdem können dann Flachspulen der Spulengruppen in mehreren Untergruppen mit jeweils mindestens zwei Flachspulen zusammengefasst werden, was weitere Vorteile ermöglicht.

Meist hat eine Spulengruppe eine gerade Anzahl von Flachspulen, z.B. vier, sechs oder acht Flachspulen. Prinzipiell ist die Anzahl von Flachspulen einer Spulengruppe nicht nach oben begrenzt, aus Gründen der einfachen Herstellung sind in der Regel nicht mehr als 20 Flachspulen übereinander angeordnet.

Bei manchen Ausführungsformen sind mindestens zwei in unterschiedlichen Schichten angeordnete Flachspulen der Spulengruppe mittels der inneren Durchkontaktierung und einer äußeren Durchkontaktierung elektrisch parallel geschaltet. Verlaufen die Windungen dieser parallel geschalteten Flachspulen gleichsinnig, so addieren sich deren elektrische Wirkungen. Es können drei, vier oder mehr Flachspulen in einer platzsparenden Anordnung parallel geschaltet sein.

Besondere Vorteile können sich ergeben, wenn Flachspulen einer Spulengruppe in mehrere Untergruppen unterteilt werden. Gemäß der beanspruchten Erfindung ist dies dadurch realisiert, dass die Flachspulen der Spulengruppe eine erste Untergruppe mit mindestens zwei ersten Flachspulen und mindestens eine zweite Untergruppe mit mindestens zwei zweiten Flachspulen bilden, wobei die Windungen der ersten Flachspulen gleichsinnig zueinander verlaufen und die Windungen der zweiten Flachspulen gleichsinnig zueinander und gegensinnig zu den Windungen der ersten Flachspulen verlaufen und wobei weiterhin äußere Anschlussenden der ersten Flachspulen über eine erste äußere Durchkontaktierung und äußere Anschlussenden der zweiten Flachspulen über eine zweite äußere Durchkontaktierung elektrisch leitend verbunden sind. Dadurch kann erreicht werden, dass sich die Wirkungen der Flachspulen einer Untergruppe jeweils aufgrund Parallelschaltung addieren und gleichzeitig die Untergruppen über die innere Durchkontaktierung elektrisch in Reihe geschaltet betrieben werden können. Bei Betrieb dieser Spulenanordnung mit einer Wechselstromquelle mit einstellbarer Stromamplitude (Stromeinprägung) wird jeder der Flachspulen ein Teilstrom aufgeprägt, der größer ist als bei einer Schaltung, in der die gleichen Flachspulen der Spulengruppe alle zueinander parallel geschaltet sind. Aufgrund der größeren Teilsströme sind auch die erzeugten Felder stärker, wodurch sich insgesamt Erregungsfelder stärkerer Intensität erzeugen lassen.

Bei einer Mehrschichtanordnung gemäß der beanspruchten Erfindung können alle Durchkontaktierungen von Spulengruppen der Mehrschichtanordnung von einer für externe Kontaktierung zugänglichen ersten Seite zu einer gegenüberliegenden, für externe Kontaktierung zugänglichen zweiten Seite durchgehen. Durch einen derartigen vereinfachten Aufbau wird die Herstellung der Mehrschichtanordnung wesentlich einfacher und kostengünstiger. Insbesondere kann es so sein, dass die Mehrschichtanordnung keine verborgenen Durchkontaktierungen und/oder keine Blind-Kontaktierungen aufweist. Eine verborgene Durchkontaktierung (im Englischen: buried via) ist eine nicht durchgehende Durchkontaktierung im Inneren der Mehrschichtanordnung, welche an beiden Enden an eine Isolierschicht stößt. Derartige Durchkontaktierungen müssen hergestellt werden, bevor die begrenzenden Isolierschichten aufgebracht werden, auf welche dann ggf. weitere Spulenschichten aufgebracht werden. Eine Blind-Durchkontaktierung (im Englischen: blind via) hat ein für die externe Kontaktierung der Mehrschichtanordnung benutzbares freies Ende, während das andere (innere) Ende an eine Isolierschicht stößt. Blind-Durchkontaktierungen finden sich häufig an den zur externen Kontaktierung zugänglichen Außenseiten von Mehrschichtanordnungen.

Ein vereinfachtes Verfahren zur Herstellung einer Mehrschicht-Wirbelstromsonde der eingangs erwähnten Art kann so durchgeführt werden, dass zunächst alle Spulenschichten und zwischen den Spulenschichten liegenden Isolierschichten ohne Durchkontaktierung zwischen Spulenschichten übereinanderliegend derart erzeugt werden, dass an mindestens einer Stelle der Mehrschichtanordnung eine Spulengruppe entsteht, die mindestens drei Flachspulen aufweist, welche in unterschiedlichen Schichten übereinander angeordnet sind und übereinander angeordnet innere Anschlussenden aufweisen, und dass danach eine von der ersten Seite zur zweiten Seite durchgehende innere Durchkontaktierung erzeugt wird, die die inneren Anschlussenden aller Flachspulen der Spulengruppe verbindet. Bis zur Erzeugung der gemeinsamen, durchgehenden Durchkontaktierung sind also für die Verschaltung der Flachspulen der Spulengruppe keine Durchkontaktierung, insbesondere keine verborgenen oder blinden Durchkontaktierungen herzustellen, wodurch die Fertigung vereinfacht wird.

Es kann ausreichen, dass die Wirbelstromsonde bzw. die Mehrschichtanordnung nur eine einzige Spulengruppe mit drei oder mehr über eine gemeinsame innere Durchkontaktierung verbundenen Flachspulen in unterschiedlichen Spulenschichten hat. Vorzugsweise wird die Mehrschichtanordnung jedoch so hergestellt, dass sie eine Vielzahl von derartigen Spulengruppen aufweist, die in einer eindimensionalen oder zweidimensionalen Feldanordnung mit lateralem Abstand nebeneinander angeordnet sind. Solche Anordnungen werden auch als "Spulen-Array" bezeichnet. Eine Mehrschichtanordnung kann also beispielsweise eine Reihe nebeneinander angeordneter Spulengruppen aufweisen, um über eine größere Prüfbreite zu prüfen, welche um ein Vielfaches größer ist als der Spulendurchmesser der Flachspulen einer Spulengruppe. Damit können Prüflingsoberflächen über relativ große Prüfbreiten gleichzeitig mit an mehreren Stellen bzw. entlang mehrerer relativ schmaler Bahnen geprüft werden. Es sind auch zweidimensionale Feldanordnungen möglich, beispielsweise mit zwei oder mehr parallel zueinander verlaufenden Reihen von Spulengruppen.

Es ist möglich, dass alle Flachspulen einer Mehrschichtanordnung im Betrieb als Feldspulen benutzt werden und dass die Wirbelstromsonde eine oder mehrere Messspulen oder andere magnetfeldsensitive Sensoren aufweist, welche gesondert von der Mehrschichtanordnung an anderer Stelle angeordnet sind, beispielsweise an der der Mehrschichtanordnung gegenüberliegenden Rückseite eines Prüflings. Vorzugsweise werden jedoch ein oder mehrere Flachspulen der Mehrschichtanordnung als Messspulen benutzt und dementsprechend im Betrieb an eine Auswerteinrichtung angeschlossen. Vorzugsweise hat die Mehrschichtanordnung eine oder mehrere als Messspulen nutzbare Flachspulen, die im Wesentlichen koaxial mit Flachspulen der Spulengruppe angeordnet sind. Beispielsweise kann mindestens eine Messspule zwischen zwei Flachspulen einer Spulengruppe angeordnet sein. Es ist alternativ oder zusätzlich auch möglich, dass eine als Messspule genutzte Flachspule über den Flachspulen einer Spulengruppe oder unter den Flachspulen einer Spulengruppe zwischen benachbarten Isolierschichten angeordnet ist. Als Messspulen genutzte Flachspulen können ebenfalls mittels Durchkontaktierungen untereinander elektrisch verbunden sein. Diese den Messspulen zugeordnete Durchkontaktierungen können im Fall koaxialer Anordnung durch den Innenbereich von Flachspulen der Spulengruppen hindurchgeführt werden. Eine derartige Verschaltung ist gut möglich, da für die elektrische Verbindung von Flachspulen einer Spulengruppe nur eine einzige Durchkontaktierung notwendig ist, so dass im Innenbereich der Flachspulen ausreichend Platz für weitere Durchkontaktierungen (für Messspulen) bleibt.

Die Erfindung betrifft auch ein Wirbelstrom-Prüfgerät mit einer elektrischen Leistungsversorgung und einer an einen Ausgang der Leistungsversorgung angeschlossenen Spulenanordnung der hier beschriebenen Art. Eine oder mehrere Spulengruppen können an diese Leistungsversorgung angeschlossen sein, um als Feldspulen zu dienen. Bei vorteilhaften Ausführungsformen ist die Leistungsversorgung dafür eingerichtet, die als Feldspulen zu nutzenden Flachspulen einer Spulenanordnung mit Erregerstrom vorgebbarer Amplitude zu versorgen, also mit Stromeinprägung zu arbeiten. Dadurch können die Vorteile der Parallelschaltung von Flachspulen optimal genutzt werden. Die Leistungsversorgung kann auch so arbeiten, dass eine feste Betriebsspannung für Flachspulen von Spulengruppen (eine oder mehrere) vorgegeben wird.

Diese und weitere Merkmale gehen außer aus den Ansprüchen auch aus der Beschreibung und den Zeichnungen hervor, wobei die einzelnen Merkmale jeweils für sich allein oder zu mehreren in Form von Unterkombinationen bei einer Ausführungsform der Erfindung und auf anderen Gebieten verwirklicht sein und vorteilhafte sowie für sich schutzfähige Ausführungen darstellen können. Ausführungsbeispiele der Erfindung sind in den Zeichnungen dargestellt und werden im Folgenden näher erläutert.

### KURZBESCHREIBUNG DER ZEICHNUNGSFIGUREN

Fig. 1 zeigt ein Wirbelstrom-Prüfgerät mit einer Mehrschicht-Wirbelstromsonde gemäß einer Ausführungsform der Erfindung;
Fig. 2 zeigt einen schematischen Vertikalschnitt durch die Mehrschicht-Spulenanordnung am Ort eines Stapels vertikal übereinanderliegender Flachspulen einer Spulengruppe;
Fig. 3 zeigt in 3A eine Draufsicht auf eine Flachspule bei einer Ausführungsform der Erfindung und in 3B zum Vergleich eine Referenz-Flachspule des Standes der Technik mit gleichem Spulendurchmesser;
Fig. 4 zeigt in 4A eine vereinfachte, schematisierte Darstellung der elektrischen Verschaltung der Flachspulen aus Fig. 2 und in 4B einen schematischen Schaltplan der gleichen Spulenanordnung;
Fig. 5 zeigt in 5A eine vereinfachte, schematisierte Darstellung der elektrischen Verschaltung der Flachspulen einer Spulengruppe mit vier gleichsinnig gewickelten, parallel geschalteten Flachspulen und in 5B einen schematischen Schaltplan der gleichen Spulenanordnung;
Fig. 6 und 7 zeigen schematisch Spulengruppen, deren Flachspulen in unterschiedliche Gruppen und diese wiederum in Untergruppen unterteilt sind.

### DETAILLIERTE BESCHREIBUNG BEVORZUGTER AUSFÜHRUNGSFORMEN

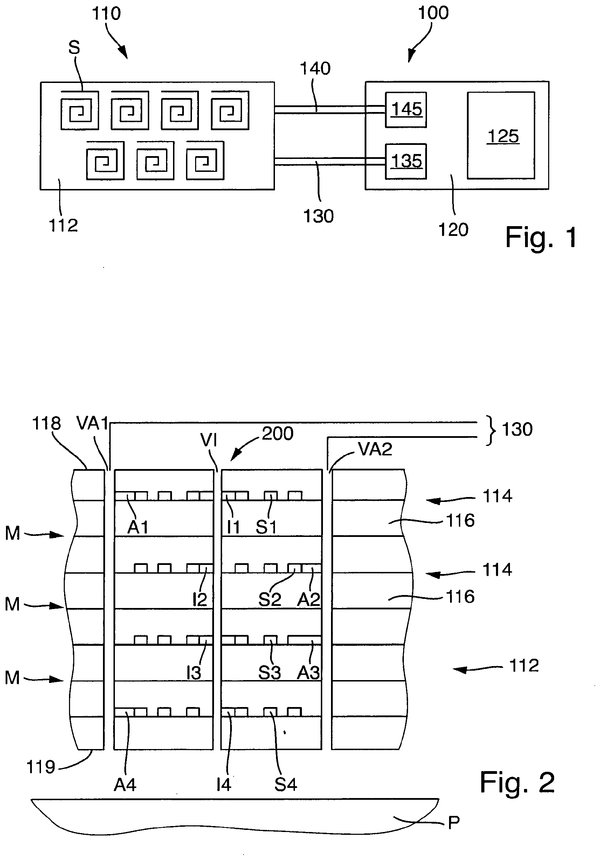

In Fig. 1 ist ein Wirbelstrom-Prüfgerät 100 gemäß einer Ausführungsform der Erfindung in schematischer Draufsicht gezeigt. Das Wirbelstrom-Prüfgerät weist eine Mehrschicht-Wirbelstromsonde 110 auf, die über eine Erregerstromleitung 130 sowie eine Messsignalleitung 140 an eine Versorgungs- und Auswerteeinheit 120 elektrisch angeschlossen ist.

Eine zentrale Komponente der Mehrschicht-Wirbelstromsonde 110 ist eine aus vielen übereinanderliegenden Materialschichten aufgebaute Mehrschicht-Spulenanordnung 112, in der viele spiralförmige Flachspulen S integriert sind, die im Beispielsfall eine Spulen-Array mit zwei zueinander parallelen Reihen übereinanderliegender Flachspulen bilden. Die Flachspulen können z.B. zeitgleich oder zeitversetzt mittels Multiplexer betrieben werden.

Der Schichtaufbau wird anhand von Fig. 2 näher erläutert. Diese zeigt einen schematischen Vertikalschnitt durch die Mehrschicht-Spulenanordnung 112 am Ort eines Stapels vertikal übereinanderliegender Flachspulen. Die Bezeichnung "vertikal" steht hier für eine Richtung senkrecht zur Ausdehnung der übereinanderliegenden Schichten.

Die in Leiterplatten-Technologie aufgebaute Mehrschicht-Spulenanordnung 112 hat Spulenschichten 114 aus elektrisch leitendem Material sowie zwischen den Spulenschichten liegende Isolierschichten 116 aus elektrisch isolierendem Material, welche die leitenden Strukturen der Spulenschichten elektrisch voneinander isolieren. Innerhalb der Spulenschichten 114 sind die Flachspulen S1 bis S4 in Form von gedruckten Leiterbahnen realisiert. Auch eventuelle elektrische Verbindungen von Flachspulen innerhalb der gleichen Spulenschicht liegen in Form von gedruckten Leiterbahnen vor.

Wie in Fig. 3A schematisch dargestellt, liegen die Windungen W einer Flachspule S in einer gemeinsamen Ebene und verlaufen spiralförmig zwischen einem äußeren Anschlussende A und einem im Inneren der Flachspule liegenden inneren Anschlussende I. Im Zentrum der mit Windungen belegten Bereiche verbleibt ein Innenbereich 152, der frei von Windungen ist. Das innere Anschlussende liegt an bzw. in diesem Innenbereich.

Die Flachspulen der Mehrschicht-Spulenanordnung 112 können in zwei Gruppen unterschiedlicher Funktion unterteilt werden. Eine erste Anzahl von Flachspulen dient zur Erregung des elektromagnetischen Feldes, welches in den Prüfling P eindringen und dort Wirbelströme erzeugen soll. Diese Flachspulen werden als Erregerspulen oder Feldspulen bezeichnet und sind über die Erregerstrom-Leitung 130 an eine Wechselspannungsquelle 135 angeschlossen, die im Beispielsfall dafür eingerichtet ist, die Feldspulen mit Wechselstrom einer vorgebbaren - und ggf. über Einstellmittel stufenlos oder in Stufen einstellbaren - Maximalamplitude der Stromstärke zu versorgen (Stromeinprägung).

Die andere Gruppe von Flachspulen, welche elektrisch gegenüber den Feldspulen isoliert sind, dienen als Messspulen der Mehrschicht-Wirbelstromsonde 110 und sind über die Messsignalleitung 140 an eine Auswerteeinrichtung 145 der Versorgungs- und Auswerteeinheit 120 angeschlossen. Ergebnisse der Wirbelstromprüfung können über eine Anzeigeeinrichtung 125 angezeigt werden, die im Beispielsfall in die Versorgungs- und Auswerteeinheit 120 integriert ist, aber auch als gesonderte Einheit vorliegen kann.

Die Feldspulen und die Messspulen sind elektrisch voneinander isoliert, aber bei der Prüfung über den Prüfling induktiv gekoppelt (transformatorische Wirbelstromsonde)

Der vertikale Schnitt in Fig. 2 zeigt beispielhaft die elektrische Verschaltung von vier Flachspulen S1 bis S4, die vertikal übereinander in unterschiedlichen Spulenschichten angeordnet sind und gemeinsam eine (vertikale) Spulengruppe 200 bilden, die als Gruppe von Feldspulen zur Felderzeugung am Ort der Spulengruppe dient. Die Windungen der ersten Flachspule S1, die der Oberseite 118 am nächsten liegt, verlaufen von der Oberseite betrachtet im Uhrzeigersinn zwischen dem äußeren Ansschlussende A1 und dem inneren Anschlussende I1. Die Windungen der der Unterseite 119 am nächsten liegenden vierten Flachspule S4 verlaufen gleichsinnig dazu zwischen ihrem äußeren Anschlussende A4 und innerem Anschlussende I4. Bei den dazwischen liegenden Flachspulen (zweite Flachspule S2 und dritte Flachspule S3) verlaufen die Windungen gegensinnig dazu, so dass die zweite und dritte Flachspule jeweils identischen Windungssinn haben, die erste und vierte Flachspule jeweils identischen Windungssinn haben und die Windungen der ersten und vierten Flachspule gegensinnig zu den Windungen der zweiten und dritten Flachspule verlaufen.

Die gleichsinnig miteinander verlaufenden Windungen der ersten und vierten Flachspule sind jeweils an eine gemeinsame erste äußere Durchkontaktierung VA1 angeschlossen. Die äußeren Anschlussenden A2 und A3 der gegensinnig dazu verlaufenden inneren Flachspulen (zweite und dritte Flachspule) sind jeweils an eine zweite äußere Durchkontaktierung VA2 elektrisch angeschlossen. Alle inneren Anschlussenden I1 bis I4 der Spulengruppe sind gemeinsam an eine durch die Innenbereiche der Flachspulen hindurch verlaufende innere Durchkontaktierung VI elektrisch angeschlossen. Alle drei Durchkontaktierungen VA1, VA2 und VI gehen jeweils von der freien Oberseite 114 zur freien Unterseite 116 durch. Für die Verschaltung der Flachspulen der Spulengruppe sind keine verborgenen Durchkontaktierungen (buried vias) oder Blindkontaktierungen (blind vias) erforderlich. Die äußeren Durchkontaktierungen VA1 und VA2 sind über Leiter der Erregerstromleitung 130 mit den Ausgängen der Wechselspannungsquelle 135 verbunden.

Messspulen können bei der Mehrschicht-Spulenanordnung 112 unter anderem zwischen den Feldspulen S1 bis S4 koaxial mit diesen in den mit M bezeichneten Spulenschichten angeordnet sein. Aus Gründen der Übersichtlichkeit sind die Messspulen nicht dargestellt. Sie können beliebige Form und Größe haben. Messspulen können als Absolutspulen oder Differenzspulen gestaltet sein. Kombinationen von Absolutspulen und Differenzspulen sind häufig nützlich.

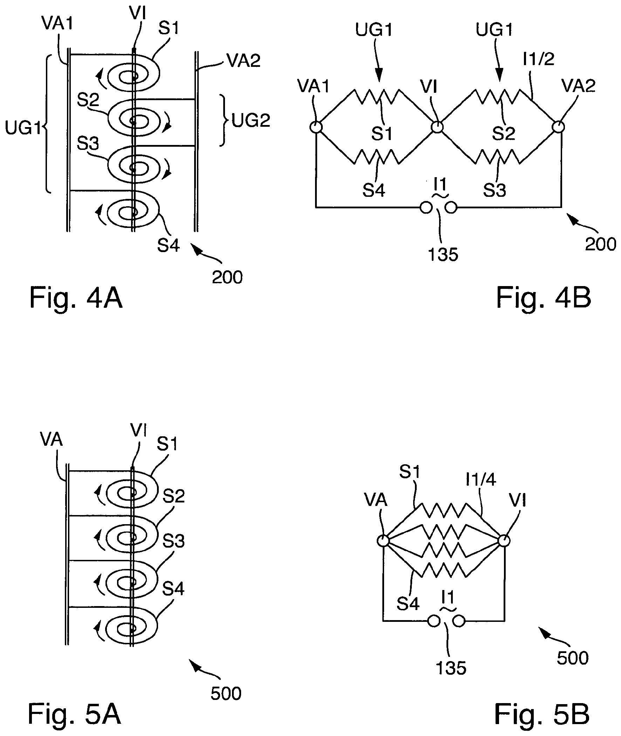

Zur weiteren Erläuterung von Aufbau und Funktion der Spulengruppe 200 aus Fig. 2 zeigt Fig. 4A eine vereinfachte, schematisierte Darstellung der elektrischen Verschaltung der Flachspulen und Fig. 4B einen schematischen Schaltplan der gleichen Spulenanordnung. Es werden die gleichen Bezugszeichen verwendet wie in Fig. 2. Die erste und vierte Flachspule S1 bzw. S4, deren Windungen gleichsinnig verlaufen und zwischen der ersten äußeren Durchkontaktierung VA1 und der inneren Durchkontaktierung VI geschaltet sind, bilden eine erste Untergruppe UG1. Die zweite und dritte Flachspule S1, S3, die gleichsinnig gewickelt und zwischen der inneren Durchkontaktierung VI und der zweiten äußeren Durchkontaktierung VA2 geschaltet sind, bilden eine zweite Untergruppe UG2. Die Windungen der Spulen einer Untergruppe verlaufen somit jeweils gleichsinnig zueinander, wobei sich der Windungssinn der Spulen der ersten Untergruppe vom Windungssinn der Spulen der zweiten Untergruppe unterscheidet.

Die Flachspulen S1, S4 der ersten Untergruppe UG1 sind parallel zueinander geschaltet. Entsprechend sind auch die Spulen S2, S3 der zweiten Untergruppe UG2 parallel zueinander geschaltet. Die Untergruppen UG1, UG2 sind in Reihe zueinander geschaltet. Die äußeren Durchkontaktierungen VA1, VA2 sind an die Ausgänge der Wechselspannungsquelle 135 angeschlossen, die innere Durchkontaktierung dient nur als interner Kontakt zwischen Flachspulen.

Alle Flachspulen sind, bis auf den Windungssinn, möglichst identisch zueinander ausgelegt (identische Spulenflächen, identische Windungszahl etc.), so dass sie möglichst gleiche Impedanzen haben.

Stellt die Wechselspannungsquelle 135 einen Erregerstrom I1 mit fest vorgegebener Stromamplitude bereit, so wird aufgrund dieser Verschaltung jede Flachspule mit einem Erregerstrom I1/n beaufschlagt, wobei n die Anzahl von zueinander parallel geschalteten Flachspulen einer Untergruppe ist. Im Beispielsfall mit n=2 wird jede Flachspule S1 bis S4 somit mit einem Erregerstrom I1/2 beaufschlagt. Wie aus Fig. 4A ersichtlich, durchfließt der Erregerstrom jede der Flachspulen zu einem gegebenen Zeitpunkt in dieselbe Umlaufrichtung, also beispielsweise gegen den Uhrzeigersinn oder mit dem Uhrzeigersinn. Dadurch überlagern sich die von den vier übereinanderliegenden Flachspulen erzeugten elektromagnetischen Felder am Ort der Spulengruppe additiv.

Es ist auch möglich, dass jede der Untergruppen mehr als zwei Flachspulen umfasst, beispielsweise drei, vier, fünf, sechs oder mehr Flachspulen. Es ist auch möglich, dass die Untergruppen unterschiedliche Anzahlen von Flachspulen aufweisen, wobei sich dann bei identischem Spulenaufbau andere Verteilungen der durch die Spulen fließenden Teilströme ergeben. Insbesondere ist es auch möglich, dass eine Untergruppe nur aus einer einzigen Flachspule besteht.

Die Figuren 5A und 5B zeigen entsprechende Darstellungen der Spulenanordnung und der elektrischen Verschaltung der Flachspulen S1 bis S4 einer Spulengruppe 500 einer nicht gemäß der beanspruchten Erfindung aufgebauten Mehrschichtanordnung Auch die Spulengruppe 500 hat vier (vertikal) übereinanderliegende Flachspulen S1 bis S4, deren innere Anschlussenden über eine gemeinsame innere Durchkontaktierung VI elektrisch miteinander verbunden sind. Alle Flachspulen sind gleichsinnig gewickelt und haben äußere Anschlussenden, die an eine gemeinsame äußere Durchkontaktierung VA angeschlossen sind. Für den Betrieb der Spulenanordnung werden die Durchkontaktierungen VA und VI an die Ausgänge einer Wechselspannungsquelle 135 angeschlossen. Diese Spulenanordnung entspricht einer Parallelschaltung aller vier Flachspulen S1 bis S4 zwischen den Durchkontaktierungen VA und VI (vergleiche Fig. 5B).

Auch bei dieser Anordnung werden zu jedem gegebenen Zeitpunkt alle vier Flachspulen S1 bis S4 vom Erregerstrom in gleicher Umlaufrichtung durchflossen, so dass sich deren erzeugte Felder addieren. Wird von der Wechselspannungsquelle 135 ein Erregerstrom I1 mit vorgegebener Amplitude erzeugt, so teilt sich dieser zwischen den Durchkontaktierungen VA und VI in vier Teilströme auf, die die jeweiligen Flachspulen durchfließen. Bei identischem Aufbau der Flachspulen und entsprechend identischer Impedanz wird somit jede Flachspule nur mit einem Teilstrom I1/4 beaufschlagt. Diese Teilströme sind somit bei identischer Stromeinprägung nur halb so groß wie die entsprechenden Teilströme bei der Ausführungsform gemäß Fig. 4.

Daraus ist ersichtlich, dass die in Fig. 4 schematisch dargestellte Aufteilung von Flachspulen in zwei (oder mehr) Untergruppen jeweils parallel geschalteter Flachspulen bei Verwendung von Leistungsversorgungen mit Stromeinprägung einen verbesserten Wirkungsgrad der Felderzeugung ermöglicht, da bei gleicher vorgegebener Stromamplitude die resultierende Erregerfeldstärke größer ist als im Falle einer Parallelschaltung ohne Aufteilung in Untergruppen (Fig. 5). Anders ausgedrückt ist es durch die Aufteilung der Spulen in Untergruppen möglich, eine gewünschte Erregerfeldstärke mit geringerer totaler Stromamplitude zu erzielen als im Falle einer Parallelschaltung ohne Aufteilung in Untergruppen.

Hinzu kommt, dass es mit Hilfe der einzigen inneren Durchkontaktierung VI möglich ist, drei oder mehr Flachspulen einer (vertikalen) Spulengruppe elektrisch zu verschalten, ohne dass mehr als eine Durchkontaktierung im Inneren der Flachspulen nötig ist. Dadurch kann der windungsfreie Innenbereich von Flachspulen im Vergleich zum Stand der Technik verkleinert werden und es können mehr Windungen pro Spulenfläche untergebracht werden. Dadurch ergibt sich im Vergleich zum Stand der Technik ein verbesserter flächenbezogener Wirkungsgrad der Flachspule, so dass beispielsweise bei vorgegebenem Erregerstrom stärkere Felder erzeugt werden können.

Zur Illustration zeigt Fig. 3B eine Referenz-Flachspule REF gemäß dem Stand der Technik, bei der im Innenbereich neben der Durchkontaktierung VI für die gezeigte Flachspule noch eine weitere Durchkontaktierung V2 zur elektrischen Verbindung anderer oberhalb und unterhalb dieser Flachspule angeordneten Flachspulen vorhanden ist. Zum Vergleich ist in Fig. 3A schematisch eine Flachspule S mit gleicher Spulenfläche, aber nur einer einzigen inneren Durchkontaktierung VI gezeigt, bei der mehr Windungen vorliegen.

Es sind zahlreiche Varianten möglich. Die Fig. 6 und 7 zeigen schematisch Beispiele von Spulengruppen, deren Flachspulen in unterschiedliche Gruppen und diese wiederum in Untergruppen unterteilt werden können, wobei jedoch alle Flachspulen einer Spulengruppe vertikal übereinanderliegen und über eine gemeinsame innere Durchkontaktierung VI verbunden sind. Die Ausführungsformen der Fig. 6 und 7 haben dabei den gleichen Aufbau der Mehrschicht-Spulenanordnung, wobei jedoch unterschiedliche Anschlussmöglichkeiten an eine bzw. zwei Leistungsversorgungen realisiert sind.

Der Aufbau wird anhand der Spulengruppe 600 in Fig. 6A erläutert. Die Spulengruppe 600 hat insgesamt acht (vertikal) übereinander angeordnete Flachspulen S1-1 bis S4-1 und S1-2 bis S4-2. Die oberen vier Flachspulen S1-1 bis S4-1 bilden eine erste Gruppe G1, deren Aufbau identisch zur Spulengruppe 200 aus Fig. 4A ist. Auf die entsprechende Beschreibung wird verwiesen. Die entsprechenden Bezugszeichen tragen jeweils den Zusatz "-1". Darunter ist eine zweite Gruppe G2 von vier Flachspulen angeordnet, deren Aufbau ebenfalls dem Aufbau der Spulengruppe 200 aus Fig. 4A entspricht. Die entsprechenden Komponenten tragen die gleichen Bezugszeichen mit dem Zusatz "-2".

Alle acht Flachspulen sind über eine einzige gemeinsame innere Durchkontaktierung VI verbunden. Sie sind jeweils in erste und zweite Untergruppen aufgeteilt, wie im Zusammenhang mit Fig. 4 beschrieben.

Die Flachspulen der ersten Gruppe G1 und der zweiten Gruppe G2 können zeitgleich oder zeitversetzt zueinander z.B. über einen Multiplexer betrieben werden. Hierzu sind die Flachspulen der ersten Gruppe G1 über die äußeren Durchkontaktierungen VA1-1 und VA2-1 mit einer ersten Leistungsversorgung 135-1 verbunden. Die äußeren Durchkontaktierungen VA1-2 und VA2-2 der zweiten Gruppe G2 sind mit einer zweiten Leistungsversorgung 135-2 verbunden, die elektrisch unabhängig von der ersten betrieben werden kann. Hierdurch ist eine variablere Einstellung der durch die Spulengruppe 600 erzeugten Feldstärke möglich, indem wahlweise nur die erste Leistungsversorgung oder nur die zweite Leistungsversorgung eingeschaltet wird oder indem beide mit jeweils vorgegebener Stromamplitude betrieben werden. Die Flachspulen der verschiedenen Gruppen können z.B. mit unterschiedlichen Frequenzen betrieben werden, um unterschiedliche Eindringtiefen zu realisieren. Die Verschaltung in Fig. 7A erlaubt wahlweise einen Betrieb der ersten Gruppe G1 oder der zweiten Gruppe G2.

Mehrschicht-Wirbelstromsonden gemäß Ausführungsformen der Erfindung bieten zahlreiche Gestaltungsmöglichkeiten sowohl hinsichtlich der elektrischen Verschaltung der Flachspulen untereinander als auch im Hinblick auf Optimierung der Sondengeometrie für unterschiedliche Anwendungsfälle. So ist es beispielsweise möglich, eine Mehrschicht-Wirbelstromsonde mit einer relativ starren bzw. biegesteifen Mehrschichtanordnung herzustellen, so dass die Mehrschicht-Wirbelstromsonde eine bestimmte vorgegebene Form, beispielsweise eine insgesamt ebene Bauform, erhält. Es ist auch möglich, Mehrschicht-Wirbelstromsonden flexibel bzw. biegsam auszugestalten, um zu erreichen, dass sich die Mehrschicht-Wirbelstromsonde an unterschiedlich gekrümmte Oberflächenformen von Prüflingen anpassen kann. In beiden Fällen ist es möglich, mit Hilfe vieler Flachspulen lateral ausgedehnte Felder (Spulen-Arrays) aufzubauen, um größere Flächenbereiche des Prüflings mit relativ kleinflächigen Flachspulen damit mit relativ hoher Ortsauflösung prüfen zu können.

## Patentansprüche

1. Mehrschicht-Wirbelstromsonde zur Verwendung in einem Wirbelstrom-Prüfgerät zur zerstörungsfreien Werkstoffprüfung elektrisch leitender Materialien mit
einer Vielzahl von spiralförmigen Flachspulen (S, S1 - S4, S1-1 - S4-1, S1-2 - S4-2), die in unterschiedlichen Spulenschichten (114) einer Mehrschichtanordnung (112) angeordnet sind, wobei
zwischen benachbarten Spulenschichten der Mehrschichtanordnung jeweils eine Isolierschicht (116) aus elektrisch isolierendem Material angeordnet ist,
jede der Flachspulen ein inneres Anschlussende (I, I1 - I4) und ein äußeres Anschlussende (A, A1 - A4) aufweist, und
ausgewählte Anschlussenden von ausgewählten Flachspulen unterschiedlicher Spulenschichten mittels Durchkontaktierungen elektrisch miteinander verbunden sind,
wobei
die Flachspulen mindestens eine Spulengruppe (200, 500, 600) bilden, die mindestens drei Flachspulen (S1 - S4, S1-1 - S4-1, S1-2 - S4-2) aufweist, die in unterschiedlichen Schichten übereinander angeordnet sind,
wobei die inneren Anschlussenden (I1 - I4) der mindestens drei Flachspulen der Spulengruppe über eine gemeinsame innere Durchkontaktierung (VI) elektrisch leitend verbunden sind,
**dadurch gekennzeichnet, dass**
Flachspulen der Spulengruppe (200, 600) eine erste Untergruppe (UG1) mit mindestens zwei ersten Flachspulen (S1, S4) und mindestens eine zweite Untergruppe (UG2) mit mindestens zwei zweiten Flachspulen (S2, S3) bilden,
wobei die Windungen der ersten Flachspulen gleichsinnig verlaufen und die Windungen der zweiten Flachspulen gleichsinnig und gegensinnig zu den Windungen der ersten Flachspulen verlaufen;
wobei äußere Anschlussenden der ersten Flachspulen über eine erste äußere Durchkontaktierung (VA1) elektrisch leitend verbunden sind und äußere Anschlussenden der zweiten Flachspulen über eine zweite äußere Durchkontaktierung (VA2) elektrisch leitend verbunden sind.

2. Mehrschicht-Wirbelstromsonde nach Anspruch 1, **dadurch gekennzeichnet, dass** mindestens zwei in unterschiedlichen Schichten angeordnete Flachspulen der Spulengruppe mittels der inneren Durchkontaktierung und einer äußeren Durchkontaktierung elektrisch parallel geschaltet sind, wobei die Windungen dieser parallel geschalteten Flachspulen gleichsinnig verlaufen.

3. Mehrschicht-Wirbelstromsonde nach Anspruch 1 oder 2, **dadurch gekennzeichnet, dass** die Spulengruppe (200, 500, 600) mindestens vier Flachspulen aufweist, die in unterschiedlichen Schichten übereinander angeordnet sind.

4. Mehrschicht-Wirbelstromsonde nach einem der vorhergehenden Ansprüche, **dadurch gekennzeichnet, dass** jede der Flachspulen (S) der Spulengruppe einen von Windungen (W) umgebenen Innenbereich (152) aufweist und dass im Innenbereich jeder der Flachspulen der Spulengruppe nur eine einzige innere Durchkontaktierung (VI) der Spulengruppe angeordnet ist.

5. Mehrschicht-Wirbelstromsonde nach einem der vorhergehenden Ansprüche, **dadurch gekennzeichnet, dass** alle Durchkontaktierungen von Spulengruppen der Mehrschichtanordnung (112) von einer für externe Kontaktierung zugänglichen ersten Seite (118) zu einer gegenüberliegenden, für externe Kontaktierung zugänglichen zweiten Seite (119) durchgehen.

6. Mehrschicht-Wirbelstromsonde nach einem der vorhergehenden Ansprüche, **dadurch gekennzeichnet, dass** die Mehrschicht-Wirbelstromsonde (110) eine Vielzahl von Spulengruppen aufweist, die in einer eindimensionalen oder zweidimensionalen Feldanordnung mit lateralem Abstand nebeneinander angeordnet sind.

7. Mehrschicht-Wirbelstromsonde nach einem der vorhergehenden Ansprüche, **dadurch gekennzeichnet, dass** eine oder mehrere Flachspulen der Mehrschichtanordnung als Messspulen vorgesehen und im Betrieb an eine Auswerteinrichtung (145) angeschlossen sind.

8. Mehrschicht-Wirbelstromsonde nach einem der vorhergehenden Ansprüche, **dadurch gekennzeichnet, dass** die Mehrschichtanordnung eine oder mehrere als Messspulen nutzbare Flachspulen aufweist, die im Wesentlichen koaxial mit Flachspulen der Spulengruppe angeordnet sind.

9. Wirbelstrom-Prüfgerät (100) zur zerstörungsfreien Werkstoffprüfung elektrisch leitender Materialien mit
einer elektrischen Leistungsversorgung (135) und einer an einen Ausgang der Leistungsversorgung angeschlossenen Mehrschicht-Wirbelstromsonde (110) gemäß einem der vorhergehenden Ansprüche.

10. Wirbelstrom-Prüfgerät nach Anspruch 9, **dadurch gekennzeichnet, dass** die Leistungsversorgung (135) dafür eingerichtet ist, Feldspulen der Mehrschicht-Wirbelstromsonde mit Erregerstrom vorgebbarer Amplitude zu versorgen.

11. Verfahren zur Herstellung einer Mehrschicht-Wirbelstromsonde gemäß einem der Ansprüche 1 bis 8, die eine Mehrschichtanordnung mit einer Vielzahl von spiralförmigen Flachspulen aufweist, welche in unterschiedlichen Spulenschichten der Mehrschichtanordnung angeordnet sind und jeweils ein inneres Anschlussende und ein äußeres Anschlussende aufweisen, wobei zwischen benachbarten Spulenschichten jeweils eine Isolierschicht aus elektrisch isolierendem Material angeordnet ist,
wobei
zunächst alle Spulenschichten und zwischen den Spulenschichten liegende Isolierschichten ohne Durchkontaktierung zwischen Spulenschichten übereinanderliegend derart erzeugt werden, dass an mindestens einer Stelle eine Spulengruppe entsteht, die mindestens drei Flachspulen aufweist, welche in unterschiedlichen Schichten übereinander angeordnet sind und übereinander angeordnete innere Anschlussenden aufweisen,
und dass danach eine von der ersten Seite zur zweiten Seite durchgehende innere Durchkontaktierung erzeugt wird, die die inneren Anschlussenden aller Flachspulen der Spulengruppe verbindet.

## Claims

1. Multi-layer eddy current probe for use in an eddy current test unit for non-destructive material testing of electrically conductive materials, comprising
a large number of flat spiral coils (S, S1 - S4, S1-1 - S4-1, S1-2 - S4-2) which are arranged in different coil layers (114) of a multi-layer arrangement (112), wherein
a respective insulating layer (116) which is composed of electrically insulating material is arranged between adjacent coil layers of the multi-layer arrangement,
each of the flat coils has an inner terminal (I, I1 - I4) and an outer terminal (A, A1 - A4), and
selected terminals of selected flat coils of different coil layers are electrically connected to one another by means of vias,
wherein
the flat coils form at least one coil group (200, 500, 600) which has at least three flat coils (S1 - S4, S1-1 - S4-1, S1-2 - S4-2) which are arranged one above the other in different layers,
wherein the inner terminals (11 - 14) of the at least three flat coils of the coil group are electrically conductively connected by means of a common inner via (VI),
**characterized in that**
flat coils of the coil group (200, 600) form a first subgroup (UG1) comprising at least two first flat coils (S1, S4) and at least one second subgroup (UG2) comprising at least two second flat coils (S2, S3),
wherein the turns of the first flat coils run with the same winding sense, and the turns of the second flat coils run with the same winding sense and with the opposite winding sense to the turns of the first flat coils;
wherein outer terminals of the first flat coils are electrically conductively connected by means of a first outer via (VA1), and outer terminals of the second flat coils are electrically conductively connected by means of a second outer via (VA2).

2. Multi-layer eddy current probe according to claim 1, **characterized in that** at least two flat coils of the coil group, which flat coils are arranged in different layers, are connected electrically in parallel by means of the inner via and an outer via, wherein the turns of these flat coils, which are connected in parallel, run with the same winding sense.

3. Multi-layer eddy current probe according to claim 1 or 2, **characterized in that** the coil group (200, 500, 600) has at least four flat coils which are arranged one above the other in different layers.

4. Multi-layer eddy current probe according to one of the preceding claims, **characterized in that** each of the flat coils (S) of the coil group has an inner region (152) which is surrounded by turns (W), and **in that** only one single inner via (VI) of the coil group is arranged in the inner region of each of the flat coils of the coil group.

5. Multi-layer eddy current probe according to one of the preceding claims, **characterized in that** all of the vias of coil groups of the multi-layer arrangement (112) pass from a first side (118) which is accessible for external contact-connection to an opposite second side (119) which is accessible for external contact-connection.

6. Multi-layer eddy current probe according to one of the preceding claims, **characterized in that** the multi-layer eddy current probe (110) has a large number of coil groups which are arranged at a lateral distance next to one another in a one-dimensional or two-dimensional field arrangement.

7. Multi-layer eddy current probe according to one of the preceding claims, **characterized in that** one or more flat coils of the multi-layer arrangement are provided as measuring coils and are connected to an evaluation device (145) during operation.

8. Multi-layer eddy current probe according to one of the preceding claims, **characterized in that** the multi-layer arrangement has one or more flat coils which can be used as measuring coils and are arranged substantially coaxially with flat coils of the coil group.

9. Eddy current test unit (100) for non-destructive material testing of electrically conductive materials, comprising
an electrical power supply (135) and a multi-layer eddy current probe (110) according to one of the preceding claims which is connected to an output of the power supply.

10. Eddy current test unit according to claim 9, **characterized in that** the power supply (135) is designed to supply excitation current of a prespecified amplitude to field coils of the multi-layer eddy current probe.

11. Method for producing a multi-layer eddy current probe according to one of the claims 1 to 8, which has a multi-layer arrangement comprising a large number of flat spiral coils which are arranged in different coil layers of the multi-layer arrangement and each have an inner terminal and an outer terminal, wherein a respective insulating layer which is composed of electrically insulating material is arranged between adjacent coil layers,
wherein
initially all of the coil layers and insulating layers which are situated between the coil layers are produced in a manner situated one above the other without through-plating between coil layers in such a way that a coil group is created at at least one location, said coil group having at least three flat coils which are arranged one above the other in different layers and have inner terminals which are arranged one above the other,
and in that thereafter an inner via which passes from the first side to the second side is produced, said inner via connecting the inner terminals of all of the flat coils of the coil group.

## Revendications

1. Sonde à courant de Foucault multicouche destinée à être utilisée dans un testeur à courant de Foucault servant au test de matériau non destructif de matériaux électriquement conducteurs, comprenant
une pluralité de bobines plates (S, S1 - S4, S1-1 - S4-1, S1-2 - S4-2) en forme de spirales qui sont disposées dans des couches de bobine (114) différentes d'un arrangement multicouche (112),
une couche isolante (116) en matériau électriquement isolant étant respectivement disposée entre des couches de bobine voisines de l'arrangement multicouche,
chacune des bobines plates possédant une extrémité de raccordement intérieure (I, I1 - I4) et une extrémité de raccordement extérieure (A, A1 - A4), et
des extrémités de raccordement choisies de bobines plates choisies de différentes couches de bobine étant reliées électriquement entre elles au moyen de contacts d'interconnexion,
les bobines plates formant au moins un groupe de bobines (200, 500, 600) qui possède au moins trois bobines plates (S1 - S4, S1-1 - S4-1, S1-2 - S4-2), lesquelles sont disposées les unes au-dessus des autres dans des couches différentes,
les extrémités de raccordement intérieures (I1 - I4) des au moins trois bobines plates du groupe de bobines étant reliées entre elles de manière électriquement conductrice par le biais d'un contact d'interconnexion interne (VI) commun,
**caractérisée en ce que**
les bobines plates du groupe de bobines (200, 600) forment un premier sous-groupe (UG1) comprenant au moins deux premières bobines plates (S1, S4) et au moins un deuxième sous-groupe (UG2) comprenant au moins deux deuxièmes bobines plates (S2, S3),
les enroulements des premières bobines plates suivant un tracé dans le même sens et les enroulements des deuxièmes bobines plates suivant un tracé dans le même sens et en sens inverse des enroulements des premières bobines plates ;
les extrémités de raccordement extérieures des premières bobines plates étant reliées de manière électriquement conductrice par le biais d'un premier contact d'interconnexion externe (VA1) et les extrémités de raccordement extérieures des deuxièmes bobines plates étant reliées de manière électriquement conductrice par le biais d'un deuxième contact d'interconnexion externe (VA2).

2. Sonde à courant de Foucault multicouche selon la revendication 1, **caractérisée en ce qu'**au moins deux bobines plates du groupe de bobines, disposées dans des couches différentes, sont branchées électriquement en parallèle au moyen d'un contact d'interconnexion interne et d'un contact d'interconnexion externe, les enroulements de ces bobines branchées en parallèle suivant un tracé dans le même sens.

3. Sonde à courant de Foucault multicouche selon la revendication 1 ou 2, **caractérisée en ce que** le groupe de bobines (200, 500, 600) possède au moins quatre bobines plates qui sont disposées les unes au-dessus des autres dans des couches différentes.

4. Sonde à courant de Foucault multicouche selon l'une des revendications précédentes, **caractérisée en ce que** chacune des bobines plates (S) du groupe de bobines possède une zone interne (152) entourée par des enroulements (W) et **en ce que** seul un contact d'interconnexion interne (VI) unique du groupe de bobines est disposé dans la zone interne de chacune des bobines plates du groupe de bobines.

5. Sonde à courant de Foucault multicouche selon l'une des revendications précédentes, **caractérisée en ce que** tous les contacts d'interconnexion des groupes de bobines traversent l'arrangement multicouche (112) d'un premier côté (118), accessible pour une mise en contact externe, à un deuxième côté (119) opposé, accessible pour une mise en contact externe.

6. Sonde à courant de Foucault multicouche selon l'une des revendications précédentes, **caractérisée en ce que** la sonde à courant de Foucault multicouche (110) possède une pluralité de groupes de bobines qui sont disposés les uns à côté des autres dans un arrangement de champ unidimensionnel ou bidimensionnel avec un écart latéral entre eux.

7. Sonde à courant de Foucault multicouche selon l'une des revendications précédentes, **caractérisée en ce qu'**une ou plusieurs bobines plates de l'arrangement multicouche sont conçues comme des bobines de mesure et, en fonctionnement, sont raccordées à un dispositif d'interprétation (145).

8. Sonde à courant de Foucault multicouche selon l'une des revendications précédentes, **caractérisée en ce que** l'arrangement multicouche possède une ou plusieurs bobines plates utilisables comme bobines de mesure et qui sont disposées de manière sensiblement coaxiale avec les bobines plates du groupe de bobines.

9. Testeur à courant de Foucault (100) servant au test de matériau non destructif de matériaux électriquement conducteurs, comprenant
une source de puissance (135) électrique et une sonde à courant de Foucault multicouche (110) selon l'une des revendications précédentes raccordée à une sortie de la source de puissance.

10. Testeur à courant de Foucault selon la revendication 9, **caractérisé en ce que** la source de puissance (135) est conçue pour alimenter les bobines de champ de la sonde à courant de Foucault multicouche avec un courant d'excitation ayant une intensité pouvant être prédéfinie.

11. Procédé de fabrication d'une sonde à courant de Foucault multicouche selon l'une des revendications 1 à 8, laquelle possède un arrangement multicouche comprenant une pluralité de bobines plates en forme de spirales qui sont disposées dans des couches de bobine différentes de l'arrangement multicouche et possèdent respectivement une extrémité de raccordement intérieure et une extrémité de raccordement extérieure, une couche isolante en matériau électriquement isolant étant respectivement disposée entre des couches de bobine voisines,
toutes les couches de bobine ainsi que les couches isolantes qui se trouvent entre les couches de bobine étant tout d'abord produites de manière disposée les unes au-dessus des autres sans contact d'interconnexion entre les couches de bobine de telle sorte qu'en au moins un endroit est créé un groupe de bobines qui possède au moins trois bobines plates, lesquelles sont disposées les unes au-dessus des autres dans des couches différentes et possèdent des extrémités de raccordement intérieures disposées les unes au-dessus des autres,
et en ce qu'un contact d'interconnexion interne continu d'un premier côté à un deuxième côté est ensuite produit, lequel relie les extrémités de raccordement intérieures de toutes les bobines plates du groupe de bobines.
